# EUROPEAN PATENT SPECIFICATION

(11) **EP 4 439 652 B1**
(45) Date of publication and mention of the grant of the patent: **07.05.2025**
(21) Application number: 23165917.8
(22) Date of filing: 31.03.2023
(51) Int. Cl.: H01L 23/373, H01L 23/40, H01L 25/065, H01L 23/00

(54) **METAL SUBSTRATE STRUCTURE AND METHOD FOR MANUFACTURING A METAL SUBSTRATE STRUCTURE FOR A SEMICONDUCTOR POWER MODULE AND SEMICONDUCTOR POWER MODULE**
METALLSUBSTRATSTRUKTUR UND VERFAHREN ZUR HERSTELLUNG EINER METALLSUBSTRATSTRUKTUR FÜR EIN HALBLEITERLEISTUNGSMODUL UND HALBLEITERLEISTUNGSMODUL
STRUCTURE DE SUBSTRAT MÉTALLIQUE ET PROCÉDÉ DE FABRICATION D'UNE STRUCTURE DE SUBSTRAT MÉTALLIQUE POUR UN MODULE DE PUISSANCE À SEMI-CONDUCTEUR ET MODULE DE PUISSANCE À SEMI-CONDUCTEUR

(43) Date of publication of application: 02.10.2024
(73) Proprietor: Hitachi Energy Ltd, 8050 Zürich (CH)
(72) Inventor: SANTOLARIA, Lluis, 4600 Olten (CH); GUILLON, David, 8857 Vorderthal (CH); TRUESSEL, Dominik, 5620 Bremgarten (CH)
(74) Representative: Epping - Hermann - Fischer

(56) References cited:
- JP-A- 2006 100 640
- JP-A- 2010 034 346
- US-A1- 2019 157 182

## Description

The present disclosure is related to a metal substrate structure and a corresponding method for manufacturing a metal substrate structure for a semiconductor power module. The present disclosure is further related to a corresponding semiconductor power module.

Semiconductor power modules form technology for low, medium and high voltage applications which experience mechanical stress due to fixing to a cooler or during thermal cycling, for example. Thus, there is a risk causing delamination, voids or cracks in module encapsulation and a metal substrate due to mechanical or thermo-mechanical stress, for example. In this respect, it is a challenge generally to prevent damages. Japanese Patent Application JP 2010 034346 A refers to a metal substrate with circuit metallization layer, metal bottom layer and isolating dielectric layer in-between with fixation areas. Japanese Patent Application JP 2006 100640 A refers to a metal substrate with circuit metallization layer, metal bottom layer and isolating dielectric layer in-between with fixation areas.

US Patent Application US 2019/157182 A1 refers to a metal substrate with metal bottom layer and isolating dielectric layer with fixation areas.

Embodiments of the disclosure relate to a stable metal substrate structure for a semiconductor power module with a reduced risk of damages occurring. Further embodiments of the disclosure relate to provide a corresponding semiconductor power module and a manufacturing method for such a metal substrate structure.

According to an embodiment, a metal substrate structure for a semiconductor power module comprises a circuit metallization layer for conducting electrical signals, e.g. signal and/or current transfer. The metal substrate structure further comprises a metal bottom layer that is coupled with the circuit metallization layer, and an isolating dielectric layer that is coupled with and arranged between the circuit metallization layer and the metal bottom layer with respect to a stacking direction of the metal substrate structure. The circuit metallization layer or the dielectric layer at least locally forms a top layer of the metal substrate structure, and the top layer and possibly the bottom layer as well comprise a fixation area configured for receiving a fixing element to fix the metal substrate structure to a further component, e.g. a cooler or a heat sink, of the semiconductor power module. At least the top layer comprises a stress relief recess that partially or completely surrounds the respective fixation area in a predetermined distance. The fixation area can also be referred to a fixation section. In particular, the metal substrate structure additionally comprises a circuit area. The circuit area in particular is the area where the electrical components, like semiconductors chips and their electrical interconnections, are arranged. The fixation area and the circuit area are arranged side by side without overlap. The fixation area for example is any area outside the circuit area. The fixation area is mainly intended for mechanical purposes.

By use of the described configuration of the metal substrate structure a reduced risk of damages is feasible when it is mounted to a cooler unit, for example. The one or more stress relief recesses that are associated to a corresponding fixation area can block or stop or at least contribute to hinder a further formation of voids or cracks that my occur during assembling the metal substrate structure by means of fixing elements. Moreover, the described configuration can also contribute to prevent and/or to block delamination of the dielectric layer from the metal bottom layer. A further propagation of damages beyond the stress relief recess is prevented or at least impeded, so that the stress relief recess acts like a firewall.

According to an embodiment of the metal substrate structure, the fixation area includes a penetrating fixation opening configured for receiving the fixing element, e.g. a screw or a bolt. The stress relief recess is formed such that it partially or completely surrounds the fixation opening in a predetermined distance.

According to an embodiment of the metal substrate structure, the stress relief recess is limited by the top layer with a form as a ring- or funnel-shaped groove around the respective fixation area. Alternatively or additionally, the stress relief recess is limited by the top layer with a conical or V-shape with respect to a cross section through the fixation area and the stress relief recess along the stacking direction. Alternatively, the stress relief recess can be limited by the top layer with a rectangular or circular shape with respect to a cross section through the fixation area and the stress relief recess along the stacking direction.

The stress relief recess penetrates the metallization layer and the dielectric layer. The respective stress relief recess can completely or partly penetrate to top layer and hence the metallization layer and/or the dielectric layer. Optionally, the respective stress relief recess can further partly penetrate the metal bottom layer.

According to a further embodiment of the metal substrate structure, the distance between the stress relief recess and the associated fixation opening or fixation area is given in coordination with the dimensions of the fixing element and with respect to the needed clamping force that is designed to be arranged in the fixation area.

According to a further embodiment of the metal substrate structure, the stress relief recess is formed in an area to provide electrical isolation of a local portion of the circuit metallization layer being in contact with the fixation element.

According to a further embodiment of the metal substrate structure, the stress relief recess comprises a predetermined depth along the stacking direction that is equal to or smaller than 2.5 mm. The formation of the stress relief recess is configured in coordination with the top layer and/or the bottom layer of the metal substrate structure and/or in coordination with the fixing element that is intended to be used and with respect to the needed clamping force.

According to a further embodiment of the metal substrate structure, the stress relief recess is formed by at least one of laser cutting, etching and computerized numerical control machining.

According to an embodiment, a semiconductor power module comprises a heat sink or cooler unit with a fixation region, e.g. a fixation opening, and an embodiment of the described metal substrate structure. The metal substrate structure is fixed to the cooler unit by a fixing element, e.g. a screw, a bolt, a spring and/or a clamp, that is arranged in the fixation area, e.g. in or close to a fixation opening, of the metal substrate structure and in the fixation region of the cooler unit.

Power semiconductor modules having baseplates, on which substrates with chips are mounted, or insulated metal substrates comprising a relative thick metal plate, an isolating layer, and a circuit metallization, are typically mounted to a cooler by screws or bolts. For this purpose, corresponding screw holes, openings or recesses are provided in the baseplate or in the insulated metal substrate.

It is a recognition in the context of the present disclosure that mechanically critical positions occur in a vicinity of openings or in areas next to a screw or bolt fitting, which realize weak points of a package design for example. Due to the described possible configurations of the metal substrate structure and its one or more stress relief recesses it is possible to counteract and limit an unwanted crack formation and/or delamination in the metal substrate structure resulting from exposed pressure and mechanical stress during assembly, in particular, and/or during operation including thermal cycles, mechanical shocks or vibrations. A further expansion of cracks or delamination beyond the stress relief recess is prevented or at least reduced so that the stress relief recess acts like a barrier.

According to an embodiment, a method for manufacturing an embodiment of the metal substrate structure comprises providing a circuit metallization layer for conducting electrical signals, providing a metal bottom layer, and providing an isolating dielectric layer. The method further comprises coupling the circuit metallization layer, the metal bottom layer and the dielectric layer with each other such that the dielectric layer is coupled with and arranged between the circuit metallization layer and the metal bottom layer with respect to a stacking direction of the metal substrate structure. The circuit metallization layer or the dielectric layer at least locally forms a top layer of the metal substrate structure. The method further comprises forming or specifying a fixation area at the top layer and the bottom layer configured for receiving a fixing element to fix the metal substrate structure to a further component of the semiconductor power module. The method further comprises forming a stress relief recess at least in the top layer that at least partially surrounds the fixation area in a predetermined distance.

The step of forming the stress relief recess can comprise forming the stress relief recess by at least one of laser cutting, etching and computerized numerical control machining or any other applicable method.

The step of providing the dielectric layer can comprise providing a resin sheet or forming the epoxy based resin layer by means of molding, for example. A resin sheet is typically filled with particles of dielectric material.

As a result of that the described semiconductor power module and the described manufacturing method comprise or are related to produce an embodiment of the metal substrate structure, described features and characteristics of the metal substrate structure are also disclosed with respect to the semiconductor power module and the manufacturing method and vice versa.

The fixation element can be realized as a screw or a bolt with an optional washer or spring washer. Alternatively or additionally, the fixation element can comprise a clamp or a spring.

The stress relief recess is formed as a groove and a location of the groove can be given as surrounding the fixation area of the metal substrate partly or completely. The groove can be located next to fixation area or the fixation opening. For example, the groove is located next to a semicircular cut-out or recess at an edge of the insulated metal substrate structure. A distance between the groove and a screw head or a washer or a spring washer or another fixation structure can have a value within 1-15 mm, for example. Other values are possible as well, in particular dependent on the size of the metal substrate structure. For example, the distance comprises a value between 1-10 mm, 1-5mm or 1-2mm.

A depth of the groove is predetermined and can penetrate only the circuit metallization layer partly or completely. Alternatively or additionally, the groove can penetrate the isolating dielectric layer partly or completely. Depending on which layer forms the top layer, the groove may penetrate only the isolation layer partly or completely, assuming there is no circuit metallization layer at that region. A bottom portion of the groove can also penetrate into the bottom metal layer. The groove may also provide electrical isolation of metal pattern being in contact with a screw or bolt or clamp head, for example. A penetration depth can have a value equal to or less than 2.5 mm, assuming the metallization layer has a thickness up to 2.0 mm with respect to the stacking direction.

The cross-sectional shape of the stress relief recess defined by the limiting contour of the one or more layers of the metal substrate structure can realize a V-cut or can have a round, rectangular or square shape.

The metal bottom layer of the insulated metal substrate structure can be made of or comprise copper, aluminum, iron, steel, or a corresponding alloy. The isolating dielectric layer can be made of or comprise epoxy resin, typically filled with particles of dielectric material, or another isolating material applicable for a lamination or molding process. The circuit metallization layer can be made of or comprise copper, aluminum, iron, steel, or a corresponding alloy.

The insulated metal substrate structure can comprise a relative thick metal base forming the bottom metal layer, an isolating sheet of epoxy resin with inorganic filler, and a circuit metallization layer. The metal plate can be completely covered by the isolating sheet and the circuit metallization except from isolating grooves for separation of circuit pattern of different electrical potential. In particular, screws or bolts can be used as fixing elements for mounting the insulated metal substrate to the cooler unit or another component of the semiconductor power module.

The screws or bolts are inserted into corresponding holes or attached to recessed portions in peripheral regions, for example. Here a bottom surface of a screw head or of an optional washer gets into contact with the circuit metallization layer or the isolating sheet and exposes pressure and/or torque on the substrate structure, such that also pressure and/or lateral forces at least during the fixation procedure and/or in operation must be considered. In view of conventional power modules, such a pressure and/or torque may result in an uncontrolled delamination or cracking of the layered structure of the insulated metal substrate, which may extend into a circuit area of chips and terminals, where high voltage levels are available. So, the delamination or cracking may significantly reduce the isolation properties and the reliability of the insulated metal substrate. By use of the described configuration of the metal substrate structure including specifically designed and located stress relief recesses in a vicinity of screw holes it is possible to counteract and/or locally limit the aforementioned adverse effects such that critical substrate regions like the circuit area are not affected.

Exemplary embodiments of the semiconductor power package are explained in the following with the aid of schematic drawings and reference numbers. The figures show:
Figures 1 - 6 embodiments of a metal substrate structure for a semiconductor power module in respective cross section side views;
Figure 7 a flow chart for a method for manufacturing an embodiment of the metal substrate structure;
Figure 8 an embodiment of the metal substrate structure in a top view; and
Figure 9 a further embodiment of the metal substrate structure in a top view.

The accompanying figures are included to provide a further understanding. It is to be understood that the embodiments shown in the figures are illustrative representations and are not necessarily drawn to scale. Identical reference numbers designate elements or components with identical functions. In so far as elements or components correspond to one another in terms of their function in different figures, the description thereof is not repeated for each of the following figures. For the sake of clarity elements might not appear with corresponding reference symbols in all figures possibly.

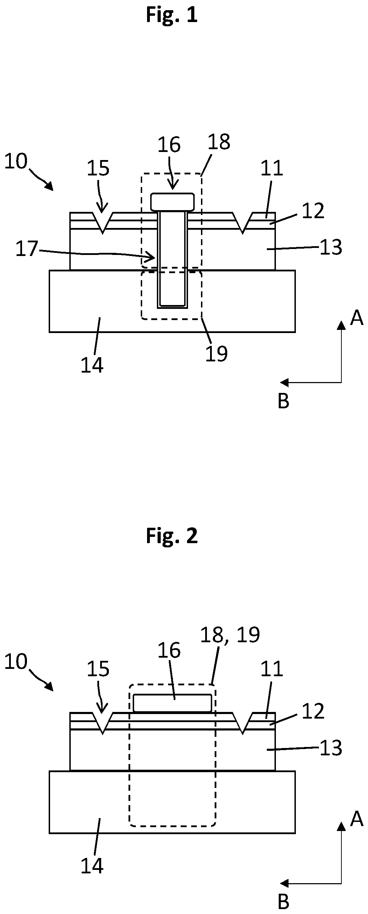

The Figures 1 - 6 illustrate different embodiments of a metal substrate structure 10 for a semiconductor power module in respective cross section side views.

The metal substrate structure 10 comprises a circuit metallization layer 11, a metal bottom layer 13 that coupled with the circuit metallization layer 11, and an isolating dielectric layer 12 that is coupled with and arranged between the circuit metallization layer 11 and the metal bottom layer 13 with respect to a stacking direction A of the metal substrate structure 10. The stacking direction A may be orientated perpendicular to a lateral direction B, C of the metal substrate structure 10.

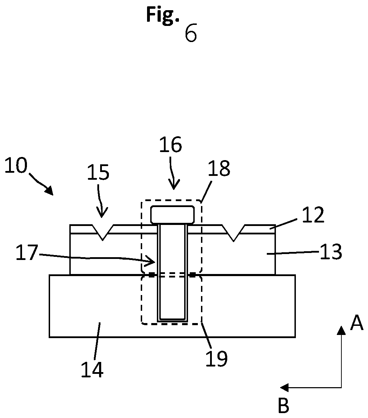

The circuit metallization layer 11 (see Figs. 1 - 5 or the dielectric layer 12 (see Fig. 6 at least locally forms a top layer of the metal substrate structure 10, and the top layer and the bottom layer 13 comprise a fixation area 18 configured for receiving a fixing element 16 to fix the metal substrate structure 10 to a further component of the semiconductor power module. The further component can be realized as a heat sink or a cooler unit 14 as shown in the Figures 1 - 6. The cooler unit 14 comprises a fixation region 19, and the metal substrate structure 10 is fixed to the cooler unit 14 by the fixing element 16 that is arranged in the fixation area 18 of the metal substrate structure 10 and in the fixation region 19 of the cooler unit 14. At least the top layer comprises a stress relief recess 15 that partially or completely surrounds the respective fixation area 18 in a predetermined distance.

By use of the described configuration of the metal substrate structure 10 a reduced risk of severe damages is feasible when it is mounted to the cooler unit 14. The one or more stress relief recesses 15 that are associated to a corresponding fixation area 18, 19 can block or stop or at least contribute to hinder a further formation of voids or cracks that my occur during assembling the metal substrate structure 10 by means of the fixing element 16. The progress of damages into a critical region, in particular into a circuit area 20, is blocked by the stress relief recesses 15, such that damages are in particular limited to a certain extension. Moreover, the described configuration can also contribute to prevent delamination of the dielectric layer 12 from the metal bottom layer 13 and/or the metallization layer 11 from the dielectric layer 12.

According to the Figures 1 and 3 - 6 the fixation area 18 of the metal substrate structure 10 and the fixation region 19 of the cooler unit 14 include a respective fixation opening 17 and the fixing element 16 is formed as a screw or bolt that extends into the fixation openings 17 and securely fixes the metal substrate structure 10 to the cooler unit 14.

Figure 2 shows a different embodiment with a fixing element 16 that is formed as a clamp and the metal substrate structure 10 is fixed to the cooler unit 14 by means of the clamp. Accordingly, there is no need for a fixation opening in the fixation area 18 of the metal substrate structure 10 and the fixation region 19 of the cooler unit 14.

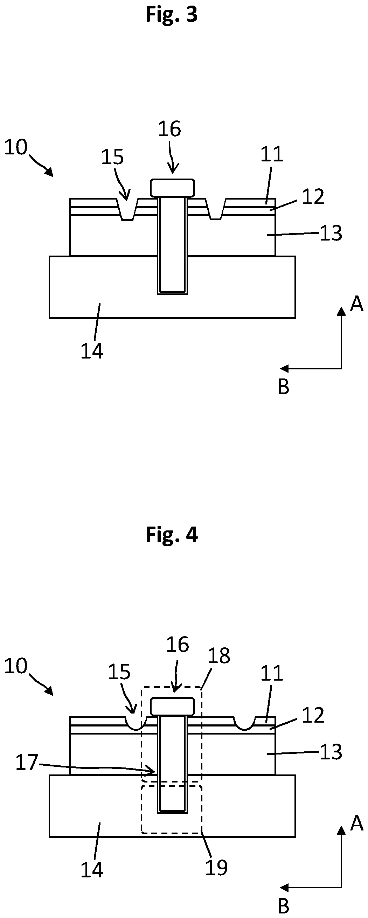

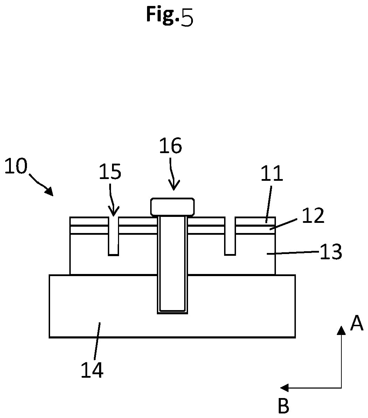

The stress relief recess 15 can comprise a V-cut cross-sectional shape (see Figs. 1, 2 and 7) that can be formed in the metal substrate structure 10 by means of laser processing, for example. The stress relief recess 15 can be limited alternatively by the corresponding layers 11, 12 and/or 13 of the metal substrate structure 10 and can comprise a conical shape (see Fig. 3), a round or circular shape (see Fig. 4) or a rectangular shape (see Fig. 5.

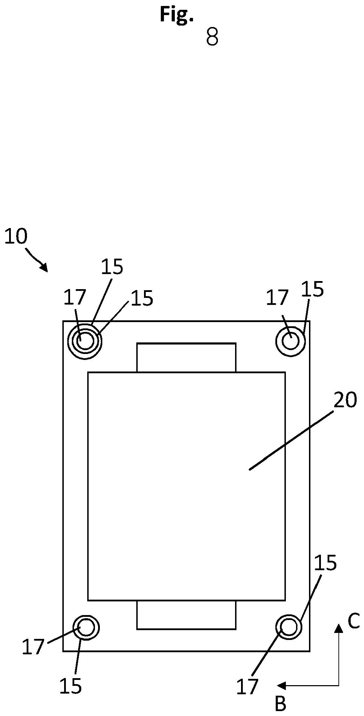

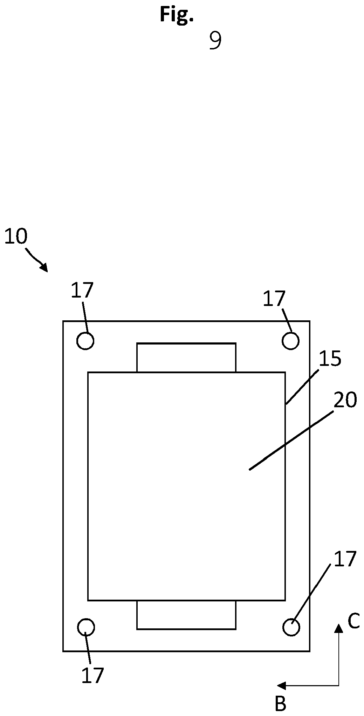

Exemplary top views are illustrated in Fig. 8 and Fig. 9.

The stress relief recess 15 can be formed to be limited by one or more of the metallization layer 11, the dielectric layer 12 and the bottom layer 13 of the metal substrate structure 10. According to the Figs. 1-3 the stress relief recess 15 is formed as a V-cut or conical groove that penetrates completely the metallization layer 11 and the dielectric layer 12 and partly the bottom layer 13.

According to Fig. 4 the stress relief recess 15 is formed as a ring-shaped groove that penetrates completely the metallization layer 11 and partly the dielectric layer 12 and that does not extend into the bottom layer 13. According to Fig. 5 the stress relief recess 15 is formed as a rectangular groove as well but the groove penetrates completely the metallization layer 11 and the dielectric layer 12 and extends deeply into the bottom layer 13.

Thus, a depth of the stress relief recess 15 can vary depending on its intended location in the metal substrate structure 10 and/or depending on a respective thickness of the layers 11, 12 and/or 13 of the metal substrate structure 10 and/or depending on the dimensions of the fixing element 16, for example, and depending on the applied force or pressure. This also applies to the other formations of the stress relief recess 15.

The distance between the stress relief recess 15 and the fixing element 16 is given along the lateral direction B and can be within 1-2 mm, for example. The distance can refer to respective center axes of the stress relief recess 15 and the fixing element 16. Alternatively, the distance can refer to points of the stress relief recess 15 and the fixing element 16 closest to each other along the lateral direction B or alternatively refer to an average distance. Accordingly, with reference to Fig. 1 the distance can be given with a predetermined value between the inner upper edge of the V-cut stress relief recess 15 and the outer surface of the screw or bolt head.

Insofar the stress relief recess 15 at least surrounds a half of the fixing element 16, the stress relief recess 15 can be formed symmetrically around the fixing element 16 as indicated in the Figs. 1-3 and 5 - 6. Alternatively, the stress relief recess 15 can be formed asymmetrically with respect to the fixing element 16 as indicated in Fig. 4.

Thus, the positioning of stress relief recess 15 and the distance between the stress relief recess 15 and the fixing element 16 can vary depending on its intended location in the metal substrate structure 10 and/or depending on a respective thickness of the layers 11, 12 and/or 13 of the metal substrate structure 10 and/or depending on the dimensions of the fixing element 16, for example. This also applies to the other formations of the stress relief recess 15 and the fixing element 16.

As shown in the top view of Fig. 8 the metal substrate structure 10 comprises the circuit area 20 which for example is arranged in a middle region of the metal substrate structure 10. The fixation area 15 is arranged outside of the circuit area 20. In a ready-to-operate condition, electric components like semiconductor chips or devices are arranged and electrically connected in the circuit area 20. As exemplarily shown in connection with the top left fixation area, the fixation opening 17 can be surrounded by a plurality of stress relief recesses 15. This is of course possible at the other fixation openings 17, too. It is possible to arrange any feasible number of stress relief recesses 15, for example two, three or four stress relief recesses 15, which are concentrically arranged or arranged in other arrangements to surround the fixation opening.

Figure 9 shows an embodiment, in which the stress relief recess 15 surrounds the circuit area 20. For example, the embodiments of Figures 8 and 9 can be combined, such that the stress relief recesses 15 surround the fixation openings 17 and a further stress relief recess 15 surrounds the circuit area 20. It is also possible that just the stress relief recesses 15 surrounding the fixation openings 17 or just the stress relief recess 15 surrounding the circuit area 20 is arranged. It is possible to arrange any feasible number of stress relief recesses 15 which surround the circuit area 20 (partially or completely), for example two, three or four stress relief recesses 15, which are arranged in layers around the circuit area 20.

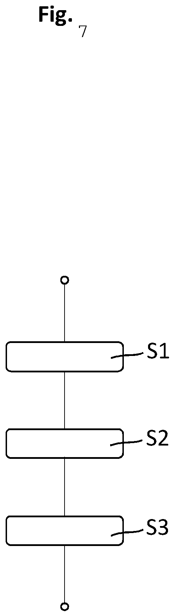

Figure 7 illustrates a flow chart for a method for manufacturing an embodiment of the metal substrate structure 10. In a step S1 the circuit metallization layer 11, the metal bottom layer 13 and the isolating dielectric layer 12 can be provided. For example, these layers 11-13 are provided with a given fixation opening 17 for receiving a screw or a bolt.

In a step S2 the circuit metallization layer 11, the metal bottom layer 13 and the dielectric layer 12 are coupled with each other such that the dielectric layer 12 is coupled with and arranged between the circuit metallization layer 11 and the metal bottom layer 13.

In a step S3 one or more stress relief recesses 15 are formed in the circuit metallization layer 11 and/or the dielectric layer 12 and optionally in the metal bottom layer 13 partly as well. The step of forming a stress relief recess 15 at least in the top layer can be done by means of laser cutting and/or etching and/or computerized numerical control machining.

Due to the described manufacturing process a stable and resistant metal substrate structure 10 is feasible and a risk of damage formation during mounting, in particular, and/or in operation including thermal cycling and mechanical shocks or vibrations can be reduced. Thus, the described embodiments can contribute to reduce a further formation of voids or cracks to at least limited possible damages and/or delamination of the dielectric layer 12 to a certain extension. A further propagation of damages beyond the stress relief recess 15 into the circuit area 20 is prevented or at least impeded, so that the stress relief recess 15 acts like a firewall to protect the circuit area 20.

A sufficient pressure, which is exposed on a surface of the mounted insulated metal substrate structure 10 by a screw head or a clamp is needed to achieve a proper thermal interface between a backside of the metal substrate structure 10 and the cooler unit 14. The screw head can be in direct contact with the top metallization layer 11, or an optional washer and/or a spring washer can be arranged between the screw head and the top metallization layer 11. So, a mechanical stress on the metal substrate structure 10 cannot be avoided, especially in the vicinity of the fixation elements.

The described embodiments of the metal substrate structure 10 and its stress relief recess 15 can enable limitation and control of the mechanical stress or a progress of damages to a certain extend. The stress relief recess 15 forms a recessed portion or a groove applied on a top surface of the insulated metal substrate structure 10, which at least partly surrounds the screw hole or the location of the screw head or the optional washer in a certain relative distance. If the pressure and/or torque applied by the head of the screw or bolt or clamp causes delamination and/or cracking, the propagation of the delamination or of cracks is stopped or at least hindered at the stress relief recess 15. A further propagation beyond the stress relief recess 15 is prevented or at least impeded, so that the stress relief recess 15 acts like a firewall.

The described configurations of the metal substrate structure 10 can enable several advantages in view of mounting of corresponding power semiconductor modules to the cooler unit 14. The insulated metal substrate structure 10 is a cost-attractive solution especially for low voltage class power modules. The proposed metal substrate structure 10 counteracts a negative impact of delamination and/or crack formation, which is caused by the pressure and/or torque exposed by the fixing element 16 due to clamping or screwing. A further propagation of damages beyond the stress relief recess is prevented or at least impeded, so that the stress relief recess acts like a firewall. If a laser-cut process is used for forming the stress relief recess 15, the preparation of a corresponding groove next to the screw positions can be integrated into the preparation process of V-cut grooves, for example, to be used for singulation of substrates. Nevertheless, the described configurations of the metal substrate structure 10 are applicable for all low voltage products and further products, if a use of an insulated metal substrate is planned.

### Reference Signs

- 10: metal substrate structure
- 11: metallization layer
- 12: dielectric layer
- 13: metal bottom layer
- 14: cooler unit
- 15: stress relief recess
- 16: fixing element
- 17: fixation opening
- 18: fixation area
- 19: fixation region
- 20: circuit area

- A: stacking direction
- B: lateral direction
- C: lateral direction
- S(i): steps of a method for manufacturing a molded power module

## Claims

1. Metal substrate structure (10) for a semiconductor power module, comprising:
- a circuit metallization layer (11) for conducting electrical signals,
- a metal bottom layer (13) that coupled with the circuit metallization layer (11), and
- an isolating dielectric layer (12) that is coupled with and arranged between the circuit metallization layer (11) and the metal bottom layer (13) with respect to a stacking direction (A) of the metal substrate structure (10), wherein the circuit metallization layer (11) or the dielectric layer (12) at least locally forms a top layer of the metal substrate structure (10),
wherein the top layer and the bottom layer (13) comprise a fixation area (18) configured for receiving a fixing element (16) to fix the metal substrate structure (10) to a further component (14) of the semiconductor power module, and wherein a stress relief recess (15) penetrates the metallization layer (11) and the dielectric layer (12).

2. Metal substrate structure (10) according to claim 1, wherein the stress relief recess (15) at least partially surrounds the respective fixation area (18) in a predetermined distance.

3. Metal substrate structure (10) according to claim 2, wherein the fixation area (18) includes a penetrating fixation opening (17) configured for receiving the fixing element (16), and the stress relief recess (15) at least partially surrounds the respective fixation opening (17) in a predetermined distance.

4. Metal substrate structure (10) according to any of the preceding claims, wherein the stress relief recess (15) is limited by the top layer with a form as a ring- or funnel-shaped groove around the respective fixation area (18).

5. Metal substrate structure (10) according to any of the preceding claims, wherein the stress relief recess (15) is limited by the top layer with a conical or V-shape with respect to a cross section through the fixation area (18) and the stress relief recess (15) along the stacking direction (A).

6. Metal substrate structure (10) according to any of the preceding claims, wherein the stress relief recess (15) is limited by the top layer with a rectangular or circular shape with respect to a cross section through the fixation area (18) and the stress relief recess (15) along the stacking direction (A).

7. Metal substrate structure (10) according to claim 6, wherein the stress relief recess (15) further penetrates partly the metal bottom layer (13).

8. Metal substrate structure (10) according to any of the preceding claims, wherein the distance between the stress relief recess (15) and the associated fixation area (18) is given in coordination with the dimensions of the fixing element (16) that is designed to be arranged in the fixation area (18).

9. Metal substrate structure (10) according to any of the preceding claims, wherein the stress relief recess (15) is formed in an area to provide electrical isolation of a local portion of the circuit metallization layer (11) being in contact with the fixation element (16).

10. Metal substrate structure (10) according to any of the preceding claims, wherein the stress relief recess (15) comprises a predetermined depth along the stacking direction (A) that is equal to or smaller than 2.5 mm.

11. Metal substrate structure (10) according to any of the preceding claims, wherein the stress relief recess (15) is formed by at least one of laser cutting, etching and computerized numerical control machining.

12. Metal substrate structure (10) according to any of the preceding claims, wherein the stress relief recess (15) at least partially surrounds a circuit area (20) in a predetermined distance.

13. Metal substrate structure (10) according to any of the preceding claims, wherein stress relief recess (15) comprises a multitude of recesses (15).

14. Semiconductor power module, comprising:
- a cooler unit (14) with a fixation region (19), and
- a metal substrate structure (10) according to any one of the preceding claims, wherein the metal substrate structure (10) is fixed to the cooler unit (14) by the fixing element (16) that is arranged in the fixation area (18) of the metal substrate structure (10) and in the fixation region (19) of the cooler unit (14).

15. Semiconductor power module according to claim 14, wherein the fixing element (16) comprises at least one of a screw, a bolt, a clamp and a spring.

16. A method for manufacturing a metal substrate structure (10) for a semiconductor power module, comprising:
- providing a circuit metallization layer (11) for conducting electrical signals,
- providing a metal bottom layer (13),
- providing an isolating dielectric layer (12),
- coupling the circuit metallization layer (11), the metal bottom layer (13) and the dielectric layer (12) with each other such that the dielectric layer (12) is coupled with and arranged between the circuit metallization layer (11) and the metal bottom layer (13) with respect to a stacking direction (A) of the metal substrate structure (10), wherein the circuit metallization layer (11) or the dielectric layer (12) at least locally forms a top layer of the metal substrate structure (10),
- forming or specifying a fixation area (18) at the top layer and the bottom layer (13) configured for receiving a fixing element (16) to fix the metal substrate structure (10) to a further component of the semiconductor power module (14), and
- forming a stress relief recess (15)that penetrates the metallization layer (11) and the dielectric layer (12).

17. The method according to claim 16, wherein the step of forming the stress relief recess (15) at least in the top layer comprises:
- forming the stress relief recess (15) by at least one of laser cutting, etching and computerized numerical control machining.

18. The method according to claim 16 or 17, wherein the step of forming the stress relief recess (15) at least in the top layer comprises:
- forming the stress relief recess (15) such that it at least partially surrounds the fixation area (18) and/or a circuit area (20) in a predetermined distance.

## Patentansprüche

1. Metallsubstratstruktur (10) für ein Halbleiterleistungsmodul, umfassend:
- eine Schaltungsmetallisierungsschicht (11) zum Leiten elektrischer Signale,
- eine unterste Metallschicht (13), die mit der Schaltungsmetallisierungsschicht (11) gekoppelt ist, und
- eine isolierende dielektrische Schicht (12), die mit der Schaltungsmetallisierungsschicht (11) und der untersten Metallschicht (13) gekoppelt und in Bezug auf eine Stapelrichtung (A) der Metallsubstratstruktur (10) zwischen diesen angeordnet ist, wobei die Schaltungsmetallisierungsschicht (11) oder die dielektrische Schicht (12) zumindest lokal eine oberste Schicht der Metallsubstratstruktur (10) bildet,
wobei die oberste Schicht und die unterste Schicht (13) einen Fixierbereich (18) umfassen, der zum Aufnehmen eines Fixierelements (16) zum Fixieren der Metallsubstratstruktur (10) an einer weiteren Komponente (14) des Halbleiterleistungsmoduls ausgelegt ist, und wobei eine Spannungsentlastungsausnehmung (15) die Metallisierungsschicht (11) und die dielektrische Schicht (12) durchdringt.

2. Metallsubstratstruktur (10) nach Anspruch 1, wobei die Spannungsentlastungsausnehmung (15) den jeweiligen Fixierbereich (18) zumindest teilweise in einem vorbestimmten Abstand umgibt.

3. Metallsubstratstruktur (10) nach Anspruch 2, wobei der Fixierbereich (18) eine durchdringende Fixieröffnung (17) beinhaltet, die zum Aufnehmen des Fixierelements (16) ausgelegt ist, und die Spannungsentlastungsausnehmung (15) die jeweilige Fixieröffnung (17) zumindest teilweise in einem vorbestimmten Abstand umgibt.

4. Metallsubstratstruktur (10) nach einem der vorhergehenden Ansprüche, wobei die Spannungsentlastungsausnehmung (15) durch die oberste Schicht mit einer Form wie eine ring- oder trichterförmige Nut um den jeweiligen Fixierbereich (18) herum begrenzt ist.

5. Metallsubstratstruktur (10) nach einem der vorhergehenden Ansprüche, wobei die Spannungsentlastungsausnehmung (15) durch die oberste Schicht mit einer konischen oder V-Form in Bezug auf einen Querschnitt durch den Fixierbereich (18) und die Spannungsentlastungsausnehmung (15) entlang der Stapelrichtung (A) begrenzt ist.

6. Metallsubstratstruktur (10) nach einem der vorhergehenden Ansprüche, wobei die Spannungsentlastungsausnehmung (15) durch die oberste Schicht mit einer rechteckigen oder kreisförmigen Form in Bezug auf einen Querschnitt durch den Fixierbereich (18) und die Spannungsentlastungsausnehmung (15) entlang der Stapelrichtung (A) begrenzt ist.

7. Metallsubstratstruktur (10) nach Anspruch 6, wobei die Spannungsentlastungsausnehmung (15) ferner die unterste Metallschicht (13) teilweise durchdringt.

8. Metallsubstratstruktur (10) nach einem der vorhergehenden Ansprüche, wobei der Abstand zwischen der Spannungsentlastungsausnehmung (15) und dem assoziierten Fixierbereich (18) in Koordination mit den Abmessungen des Fixierelements (16) gegeben ist, das dazu ausgelegt ist, in dem Fixierbereich (18) angeordnet zu werden.

9. Metallsubstratstruktur (10) nach einem der vorhergehenden Ansprüche, wobei die Spannungsentlastungsausnehmung (15) in einem Bereich ausgebildet ist, um elektrische Isolierung eines lokalen Abschnitts der Schaltungsmetallisierungsschicht (11) bereitzustellen, der mit dem Fixierelement (16) in Kontakt ist.

10. Metallsubstratstruktur (10) nach einem der vorhergehenden Ansprüche, wobei die Spannungsentlastungsausnehmung (15) eine vorbestimmte Tiefe entlang der Stapelrichtung (A) umfasst, die gleich oder kleiner als 2,5 mm ist.

11. Metallsubstratstruktur (10) nach einem der vorhergehenden Ansprüche, wobei die Spannungsentlastungsausnehmung (15) durch mindestens eines von Laserschneiden, Ätzen und Bearbeitung mittels computergestützter numerischer Steuerung gebildet ist.

12. Metallsubstratstruktur (10) nach einem der vorhergehenden Ansprüche, wobei die Spannungsentlastungsausnehmung (15) einen Schaltungsbereich (20) zumindest teilweise in einem vorbestimmten Abstand umgibt.

13. Metallsubstratstruktur (10) nach einem der vorhergehenden Ansprüche, wobei die Spannungsentlastungsausnehmung (15) eine Vielzahl von Ausnehmungen (15) umfasst.

14. Halbleiterleistungsmodul, umfassend:
- eine Kühlereinheit (14) mit einer Fixierregion (19), und
- eine Metallsubstratstruktur (10) nach einem der vorhergehenden Ansprüche, wobei die Metallsubstratstruktur (10) durch das Fixierelement (16), das in dem Fixierbereich (18) der Metallsubstratstruktur (10) und in der Fixierregion (19) der Kühlereinheit (14) angeordnet ist, an der Kühlereinheit (14) fixiert ist.

15. Halbleiterleistungsmodul nach Anspruch 14, wobei das Fixierelement (16) mindestens eines von einer Schraube, einem Bolzen, einer Klemme und einer Feder umfasst.

16. Verfahren zum Herstellen einer Metallsubstratstruktur (10) für ein Halbleiterleistungsmodul, umfassend:
- Bereitstellen einer Schaltungsmetallisierungsschicht (11) zum Leiten elektrischer Signale,
- Bereitstellen einer untersten Metallschicht (13),
- Bereitstellen einer isolierenden dielektrischen Schicht (12),
- Koppeln der Schaltungsmetallisierungsschicht (11), der untersten Metallschicht (13) und der dielektrischen Schicht (12) derart miteinander, dass die dielektrische Schicht (12) mit der Schaltungsmetallisierungsschicht (11) und der untersten Metallschicht (13) gekoppelt und in Bezug auf eine Stapelrichtung (A) der Metallsubstratstruktur (10) zwischen diesen angeordnet ist, wobei die Schaltungsmetallisierungsschicht (11) oder die dielektrische Schicht (12) zumindest lokal eine oberste Schicht (10) der Metallsubstratstruktur bildet,
- Bilden oder Spezifizieren eines Fixierbereichs (18) an der obersten Schicht und der untersten Schicht (13), der zum Aufnehmen eines Fixierelements (16) ausgelegt ist, um die Metallsubstratstruktur (10) an einer weiteren Komponente des Halbleiterleistungsmoduls (14) zu fixieren, und
- Bilden einer Spannungsentlastungsausnehmung (15), die die Metallisierungsschicht (11) und die dielektrische Schicht (12) durchdringt.

17. Verfahren nach Anspruch 16, wobei der Schritt des Bildens der Spannungsentlastungsausnehmung (15) zumindest in der obersten Schicht Folgendes umfasst:
- Bilden der Spannungsentlastungsausnehmung (15) durch mindestens eines von Laserschneiden, Ätzen und Bearbeitung mittels computergestützter numerischer Steuerung.

18. Verfahren nach Anspruch 16 oder 17, wobei der Schritt des Bildens der Spannungsentlastungsausnehmung (15) zumindest in der obersten Schicht Folgendes umfasst:
- derartiges Bilden der Spannungsentlastungsausnehmung (15), dass sie den Fixierbereich (18) und/oder einen Schaltungsbereich (20) zumindest teilweise in einem vorbestimmten Abstand umgibt.

## Revendications

1. Structure de substrat métallique (10) pour un module de puissance à semi-conducteur, comprenant :
- une couche de métallisation de circuit (11) pour conduire des signaux électriques,
- une couche inférieure métallique (13) couplée à la couche de métallisation de circuit (11), et
- une couche diélectrique isolante (12) qui est couplée à et agencée entre la couche de métallisation de circuit (11) et la couche inférieure métallique (13) par rapport à une direction d'empilement (A) de la structure de substrat métallique (10), la couche de métallisation de circuit (11) ou la couche diélectrique (12) formant au moins localement une couche supérieure de la structure de substrat métallique (10),
la couche supérieure et la couche inférieure (13) comprenant une zone de fixation (18) configurée pour recevoir un élément de fixation (16) afin de fixer la structure de substrat métallique (10) à un autre composant (14) du module de puissance à semi-conducteur, et un évidement de soulagement de contrainte (15) pénétrant dans la couche de métallisation (11) et la couche diélectrique (12).

2. Structure de substrat métallique (10) selon la revendication 1, l'évidement de soulagement de contrainte (15) entourant au moins partiellement la zone de fixation respective (18) sur une distance prédéterminée.

3. Structure de substrat métallique (10) selon la revendication 2, la zone de fixation (18) comprenant une ouverture de fixation pénétrante (17) configurée pour recevoir l'élément de fixation (16), et l'évidement de soulagement de contrainte (15) entourant au moins partiellement l'ouverture de fixation respective (17) à une distance prédéterminée.

4. Structure de substrat métallique (10) selon l'une quelconque des revendications précédentes, l'évidement de soulagement de contrainte (15) étant limité par la couche supérieure sous la forme d'une rainure en forme d'anneau ou d'entonnoir autour de la zone de fixation respective (18).

5. Structure de substrat métallique (10) selon l'une quelconque des revendications précédentes, l'évidement de soulagement de contrainte (15) étant limité par la couche supérieure avec une forme conique ou en V par rapport à une section transversale à travers la zone de fixation (18) et l'évidement de soulagement de contrainte (15) le long de la direction d'empilement (A).

6. Structure de substrat métallique (10) selon l'une quelconque des revendications précédentes, l'évidement de soulagement de contrainte (15) étant limité par la couche supérieure avec une forme rectangulaire ou circulaire par rapport à une section transversale à travers la zone de fixation (18) et l'évidement de soulagement de contrainte (15) le long de la direction d'empilement (A).

7. Structure de substrat métallique (10) selon la revendication 6, l'évidement de soulagement de contrainte (15) pénétrant en outre en partie dans la couche inférieure métallique (13).

8. Structure de substrat métallique (10) selon l'une quelconque des revendications précédentes, la distance entre l'évidement de soulagement de contrainte (15) et la zone de fixation associée (18) étant donnée en coordination avec les dimensions de l'élément de fixation (16) qui est conçu pour être agencé dans la zone de fixation (18).

9. Structure de substrat métallique (10) selon l'une quelconque des revendications précédentes, l'évidement de soulagement de contrainte (15) étant formé dans une zone permettant d'assurer l'isolation électrique d'une partie locale de la couche de métallisation de circuit (11) qui est en contact avec l'élément de fixation (16).

10. Structure de substrat métallique (10) selon l'une quelconque des revendications précédentes, l'évidement de soulagement de contrainte (15) comprenant une profondeur prédéterminée le long de la direction d'empilement (A) qui est égale ou inférieure à 2,5 mm.

11. Structure de substrat métallique (10) selon l'une quelconque des revendications précédentes, l'évidement de soulagement de contrainte (15) étant formé par au moins l'un des procédés suivants : découpe au laser, gravure et usinage par commande numérique informatisée.

12. Structure de substrat métallique (10) selon l'une quelconque des revendications précédentes, l'évidement de soulagement de contrainte (15) entourant au moins partiellement une zone de circuit (20) sur une distance prédéterminée.

13. Structure de substrat métallique (10) selon l'une quelconque des revendications précédentes, l'évidement de soulagement de contrainte (15) comprenant une multitude d'évidements (15).

14. Module de puissance à semi-conducteur, comprenant :
- une unité de refroidissement (14) avec une région de fixation (19), et
- une structure de substrat métallique (10) selon l'une quelconque des revendications précédentes, la structure de substrat métallique (10) étant fixée à l'unité de refroidissement (14) par l'élément de fixation (16) qui est agencé dans la zone de fixation (18) de la structure de substrat métallique (10) et dans la région de fixation (19) de l'unité de refroidissement (14).

15. Module de puissance à semi-conducteur selon la revendication 14, l'élément de fixation (16) comprenant au moins un élément parmi une vis, un boulon, un collier et un ressort.

16. Procédé de fabrication d'une structure de substrat métallique (10) pour un module de puissance à semi-conducteur, comprenant :
- la fourniture d'une couche de métallisation de circuit (11) pour conduire les signaux électriques,
- la fourniture d'une couche inférieure métallique (13),
- la fourniture d'une couche diélectrique isolante (12),
- le couplage de la couche de métallisation de circuit (11), de la couche inférieure métallique (13) et de la couche diélectrique (12) entre elles de sorte que la couche diélectrique (12) soit couplée et agencée entre la couche de métallisation de circuit (11) et la couche inférieure métallique (13) par rapport à une direction d'empilement (A) de la structure de substrat métallique (10), la couche de métallisation de circuit (11) ou la couche diélectrique (12) formant au moins localement une couche supérieure de la structure de substrat métallique (10),
- la formation ou la spécification d'une zone de fixation (18) au niveau de la couche supérieure et de la couche inférieure (13) configurée pour recevoir un élément de fixation (16) afin de fixer la structure de substrat métallique (10) à un autre composant du module de puissance à semi-conducteur (14), et
- la formation d'un évidement de soulagement de contrainte (15) qui pénètre la couche de métallisation (11) et la couche diélectrique (12).

17. Procédé selon la revendication 16, l'étape de formation de l'évidement de soulagement de contrainte (15) au moins dans la couche supérieure comprenant :
- la formation de l'évidement de soulagement de contrainte (15) par au moins l'un des procédés suivants : découpe au laser, gravure et usinage à commande numérique informatisée.

18. Procédé selon la revendication 16 ou 17, l'étape de formation de l'évidement de soulagement de contrainte (15) au moins dans la couche supérieure comprenant :
- la formation de l'évidement de soulagement de contrainte (15) de telle sorte qu'il entoure au moins partiellement la zone de fixation (18) et/ou une zone de circuit (20) sur une distance prédéterminée.
